Europäisches Patentamt

European Patent Office

Office européen des brevets

(19)

(11) Veröffentlichungsnummer: **0 046 605**
**A2**

## (12) EUROPÄISCHE PATENTANMELDUNG

(21) Anmeldenummer: **81200715.1**

(22) Anmeldetag: **24.06.81**

(51) Int. Cl.³: **H 05 K 7/20**
**H 01 L 23/34, H 01 L 23/24**
**H 01 L 23/08**

(30) Priorität: **23.08.80 DE 3031912**

(43) Veröffentlichungstag der Anmeldung:
**03.03.82 Patentblatt 82/9**

(84) Benannte Vertragsstaaten:
**CH DE FR LI SE**

(71) Anmelder: **BBC Aktiengesellschaft Brown, Boveri & Cie.**

**CH-5401 Baden(CH)**

(72) Erfinder: **Jester, Alfred**
**Friedrich-Hoelderlinweg 7**
**D-6720 Speyer(DE)**

(72) Erfinder: **Kuhn, Werner**
**Eichenstrasse 23**
**D-6944 Hemsbach(DE)**

(54) Anordnung zur potentialunabhängigen Wärmeabführung.

(57) Es wird eine Anordnung zur Wärmeabführung der in elektrischen bzw. elektronischen Bauteilen entstehenden Verlustwärme vorgeschlagen. Die aktiven und passiven Bauteile, insbesondere Dünnschichtwiderstände, sind dabei auf einem Keramiksubstrat (1) angeordnet bzw. aufgebracht. Das Keramiksubstrat (1) ist über ein elastisches Bündel von Einzelstegen (2) potentialunabhängig mit einer Wärmeableitplatte (3) zu einem Modul, insbesondere einem Beschaltungsmodul für Leistungs-Halbleiterbauelemente, vereint.

Fig. 1

EP 0 046 605 A2

600/80

BBC Aktiengesellschaft Brown, Boveri & Cie., Baden

Anordnung zur potentialunabhängigen Wärmeabführung.

Die Erfindung bezieht sich auf eine Anordnung zur Wärmeabführung der in elektrischen bzw. elektronischen Bauteilen entstehenden Verlustwärme, mit einer Wärmeableitplatte und einem daran stoffschlüssig angeschlossenen elastischen Bündel von Einzelstegen. Eine derartige Anordnung ist aus der DE-OS 28 55 493 bekannt.

Die Wärmeabfuhr von aktiven und passiven Bauelementen, die sich auf unterschiedlichen elektrischen Potentialen befinden, ist eines der Hauptprobleme der Leistungselektronik, insbesondere dann, wenn solche Bauteile in sogenannten Modulen integriert werden sollen.

In der Hybridtechnik werden aktive und passive Bauelemente auf einem gemeinsamen Substrat angeordnet. Als Substrate werden u. a. Kunststoffolien, Keramik-Scheiben und emaillierte Stahlplatten eingesetzt. Bei dieser Integrationstechnik ist die erzielbare Leistungsdichte auf Werte unter 5 W/cm² limitiert, da die anfallende Verlustwärme vorzugsweise durch Konvektion an die Umgebung abgeführt wird.

Bei dem Bestreben, immer größere Leistungen auf immer kleinerem Raum umzusetzen, besteht die Notwendigkeit, eine Plattform bereitzustellen, die einerseits eine hohe elektrische Isolierfähigkeit gewährleistet und andererseits eine intensive Kühlung von der Rückseite her ermöglicht.

Dünne Keramikscheiben als Wärmeleitstrecken besitzen neben guten elektrischen auch relativ gute thermische Eigenschaften hinsichtlich der Wärmeleitfähigkeit ($Al_2O_3$ : Wärmeleitfähigkeit $\lambda \sim 0,4$ W/cm °K, BeO: $\lambda \sim 1,6$ W/cm °K). So beträgt z.B. der Temperaturabfall über eine 1 mm dicke $Al_2O_3$-Scheibe bei einer Leistungsdichte von 50 W/cm² ca. 12,5 °C, im Falle BeO sogar nur 3,2 °C. Mit Hilfe dieser Materialien könnte die Verlustwärme direkt an eine gekühlte Schiene abgeführt werden, ohne daß eine Transformation der Wärmestromdichte erforderlich wäre. Das Problem dieser keramischen Materialien liegt aber bei ihren gegenüber Kupfer rund um den Faktor 2 niedrigeren thermischen Ausdehnungskoeffizienten und ihrer Bruchanfälligkeit. Großflächige Kontakte Kupfer-Keramik-Kupfer sind wegen des plastischen Verhaltens von Kupfer im Prinzip zwar herstellbar, jedoch sehr anfällig gegen thermische und mechanische Belastungen. Diese Belastungen führen zu Rissen in der Keramik, die ihrerseits die elektrische Durchschlagfestigkeit stark herabsetzen.

Aus der DE-OS 28 55 494 ist eine elektrisch isolierende Wärmeableitscheibe bekannt, die sich als Tragplatte oder Anschlußplatte für hochbelastete elektrische und elektronische Bauelemente, integrierte Schaltungen usw. eignet. Die Wärmeableitscheibe besteht dabei aus einer Vielzahl einzelner Keramikscheiben, die in Kunststoff eingebettet sind. Die Keramikscheiben eignen sich infolge ihrer guten thermischen Eigenschaften zur Abfuhr von Verlustwärme. Durch Einstellen des Füllgrades zwischen Keramikscheibe und Kunststoff ist eine Anpassung des Ausdehnungskoeffizienten der Wärmeableitscheibe an den des Metalls des anzuschließenden Kühlkörpers möglich.

Aus der DE-OS 28 55 493 ist ein Leistungs-Halbleiterbauelement bekannt, an dessen Halbleiterscheibe zu beiden Seiten je ein Bündel von Metalldrähten angelötet ist. Die anderen Enden der Metalldrähte sind mit Wärmeableitscheiben verlötet. Die Metalldrähte besitzen mit zunehmendem Abstand vom Zentrum eine zunehmende Länge, um unterschiedliche Wärmeausdehnungen von Halbleiterscheibe und Wärmeableitscheiben abzufangen.

Diese bekannte Anordnung ermöglicht eine stoffschlüssige Verbindung zwischen Silizium und Kupfer, die die unterschiedliche thermische Ausdehnung beider Materialien berücksichtigt.

Der Erfindung liegt davon ausgehend die Aufgabe zugrunde, eine elektrisch isolierende Anordnung zur Abführung der in elektrischen bzw. elektronischen Bauteilen entstehenden Wärme zu schaffen.

Diese Aufgabe wird erfindungsgemäß dadurch gelöst, daß aktive und passive Bauelemente, insbesondere Widerstände, auf einem Keramiksubstrat angeordnet bzw. aufgebracht sind, wobei das Keramiksubstrat über das elastische Bündel von Einzelstegen potentialunabhängig mit der Wärmeableitplatte zu einem Modul, insbesondere einem Beschaltungsmodul für Leistungs-Halbleiterbauelemente vereint ist.

Die mit der Erfindung erzielbaren Vorteile bestehen insbesondere darin, daß die vorgeschlagene Anordnung eine intensive Kühlung der elektrischen bzw. elektronischen Bauteile bei gleichzeitig guter elektrischer Isolation gewährleistet.

Eine Ausgestaltung der Erfindung ist gekennzeichnet durch eine Ausführung der auf das Keramiksubstrat aufgebrachten Widerstände als Dünnschicht-Widerstände. Dadurch wird eine hohe Stoßbelastbarkeit (kurzzeitige Leistungsspitzen) ermöglicht.

Ein Ausführungsbeispiel der Erfindung ist im folgenden anhand der Zeichnungen erläutert.

Es zeigen:

Fig. 1     eine Plattform zur potentialfreien Wärmeabfuhr,

Fig. 2+3   die stationären inneren Spannungen im Keramiksubstrat,

Fig. 4     die dynamischen inneren Spannungen im Keramiksubstrat,

Fig. 5     Temperaturerhöhung des Keramiksubstrats bei
           Stoßbeanspruchung,

Fig. 6     zeitabhängiger Temperaturanstieg der Keramikoberfläche bei Stoßbelastung,

Fig. 7     ein Thyristor-Beschaltungsmodul,

Fig. 8     ein Widerstandsmodul.

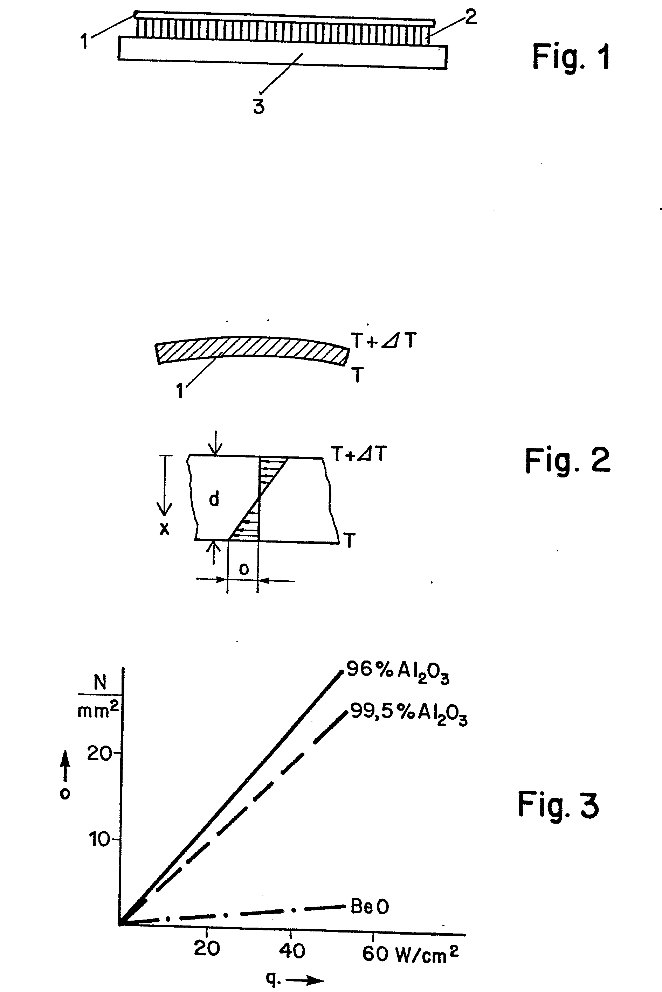

In Fig. 1 ist die erfindungsgemäße Plattform zur potentialfreien Wärmeabfuhr dargestellt. Ein Keramiksubstrat 1 (z.B. $Al_2O_3$, BeO o. ä.) ist über ein elastisches Bündel von Einzelstegen 2 (z.B. Bürstenpaket oder geschlitztes aufgewickeltes Band) mit einer Wärmeableitplatte 3 (z.B. Kupferplatte) stoffschlüssig verbunden. Die Wärmeableitplatte 3 kann z.B. intensiv mit Hilfe einer (nicht dargestellten) Kühleinrichtung gekühlt werden.

Die Ausführung eines Bürstenpaketes ist in der DE-OS 28 55 493 beschrieben, wie bereits erwähnt. Auf die Oberfläche des Keramiksubstrates 1 wird dabei ein Bündel von Metalldrähten angelötet. Die anderen Enden der Metalldrähte sind mit der Wärmeableitplatte 3 verlötet. Die Metalldrähte können mit zunehmendem Abstand vom Zentrum des Substrates 1 eine zunehmende Länge besitzen, um unterschiedliche Wärmeausdehnungen von Keramiksubstrat 1 und Wärmeableitscheibe 3 aufzufangen.

Die Ausführung eines geschlitzten aufgewickelten Bandes ist in der Patentanmeldung P 29 37 049.8 beschrieben. Es handelt sich dabei um ein zu einer Spirale aufgewickeltes Kupferband. In das Kupferband sind Querschlitze geätzt oder gestanzt, so daß einseitig freie Stege gebildet werden. Die Enden der Stege werden mit dem Keramiksubstrat 1 stoffschlüssig verbunden, wobei jedoch die Stege untereinander keine Verbindung eingehen dürfen. Die andere Seite des aufgerollten Bandes wird mit der Wärmeableitplatte 3 verlötet. Die Wärmeausdehnungsdifferenzen zwischen Wärmeableitplatte 3 und Keramiksubstrat 1 sowie Fertigungstoleranzen in der Planheit der Wärmeableitplatte 3 und des Keramiksubstrates 1 werden durch entsprechende V-Form der Stege elastisch aufgefangen.

Der Wärmewiderstand einer solchen Anordnung setzt sich zusammen aus den einzelnen Widerständen des Keramiksubstrats 1, des Bürstenpaketes 2 und der Kupferplatte 3 bei Vernachlässigung der Übergangswiderstände an den Verbindungsstellen. Im einzelnen ergeben sich folgende Werte:

- Wärmewiderstand des Keramiksubstrates bei 1 mm Dicke
  $R_{thKer} \approx 0,06$ bzw. $0,4$ $(Kcm^2/W)$ für BeO bzw. $Al_2O_3$
- Wärmewiderstand des als elastisches Bündel von Einzelstegen dienenden Bürstenpaketes bei 50% Füllgrad und 5 mm Dicke
  $R_{thCu-B} = 0,26$ $(Kcm^2/W)$
- Wärmewiderstand der als Wärmeableitplatte eingesetzten Kupferscheibe
  $R_{thCu} = 0,13$ $(Kcm^2/W)$

Insgesamt ergibt sich also ein Gesamt-Wärmewiderstand von 0,79 (Kcm²/W) für $Al_2O_3$ bzw. 0,45 (Kcm²/W) für BeO.

Hieraus ist ersichtlich, daß Wärmestromdichten in der Größenordnung von 50 bis 100 W/cm² realisierbar sind. Somit bietet sich die Möglichkeit, auch Leistungswiderstände, wie sie z.B. bei der Beschaltung von Leistungshalbleitern eingesetzt werden, auf einem Substrat 1 zu einem Modul zusammenzufassen. Die Auslegung der Parameter Länge, Breite und Dicke der Widerstandsschicht hat dabei so zu erfolgen, daß eine maximale, vorgegebene Wärmestromdichte nicht überschritten wird. Für einen 100 W-Widerstand sind z.B. 5 cm² Fläche vorzusehen, wenn die maximale Wärmestromdichte auf 20 W/cm² festgelegt wird.

Der durch den Wärmestrom im Keramiksubstrat 1 erzeugte Temperaturabfall hat stationäre innere Spannungen zur Folge, wie in Fig. 2 gezeigt ist. An der z.B. mit Dünnschicht-Widerständen beschichteten Oberseite des Keramiksubstrats 1 herrscht die Temperatur $T + \Delta T$, an der Unterseite die Temperatur T. Die Behinderung der freien thermischen Ausdehnung führt zu stationären inneren Wärmespannungen $\sigma$ im Keramiksubstrat

$$\sigma = \pm \frac{E \cdot \alpha \cdot \Delta t}{2(1-v)}$$

wobei $\Delta T = \dot{q}_0 \cdot R_{th}$

mit

$E$ = Elastizitätsmodul (N/mm²)

$\alpha$ = therm. Ausdehnungskoeffizient ($K^{-1}$)

$v$ = Poissionzahl des betreffenden Materials

$\Delta T$ = Temperaturdifferenz (K)

$R_{th}$ = thermischer Widerstand (K/W/cm²)

$\dot{q}_0$ = Wärmestromdichte (W/cm²)

In Fig. 3 sind diese stationären inneren Wärmespannungen im Keramiksubstrat 1 in Abhängigkeit der Wärmestromdichte $\dot{q}_o$ aufgetragen. Für $Al_2O_3$ bzw. BeO gilt näherungsweise $\sigma \approx \pm 1,5 \, \Delta T$ ($N/mm^2$).

Bei Beschaltungswiderständen für Leistungshalbleiter fällt die abzuführende Wärmeleistung in periodisch wiederkehrenden Leistungsspitzen von ca. 10 µs Dauer an. Diese Leistungsspitzen können bei 100 W mittlerer Dauerleistung bis zu 50 000 W betragen. In diesem Fall wird dem stationären Anteil der inneren Spannungen noch ein dynamischer Anteil überlagert, was kurzzeitige Temperaturerhöhungen zur Folge hat.

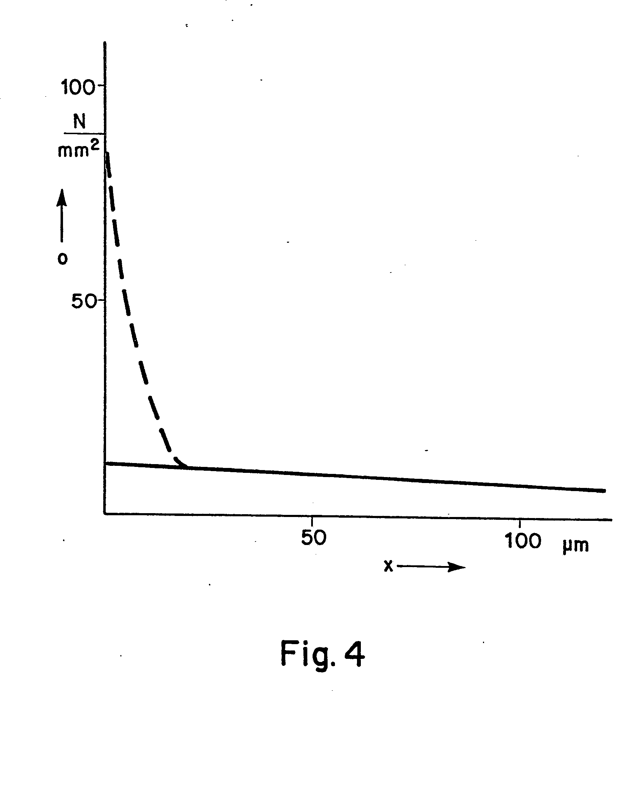

In Fig. 4 ist die Summe aus dynamischer und stationärer innerer Druckspannung $\sigma$ im Keramiksubstrat in Abhängigkeit des Abstandes x von der Substratoberfläche dargestellt (siehe auch Fig. 2). Der durchgezogene Linienzug stellt dabei den stationären, der gestrichelte Linienzug den dynamischen Anteil der inneren Spannungen dar.

Es ergibt sich

$$\sigma = \sigma_0 \left(1 - \frac{x}{d/2}\right) + \sigma_1(x,t)$$

mit

$$\sigma_0 = \frac{E \cdot \alpha}{2(1-v)} \cdot \dot{q}_o \cdot R_{th} = \text{stationärer Anteil}$$

und

$$\sigma_1(x,t) = \frac{E \cdot \alpha}{1-v} \cdot \Delta T(x,t) \quad \text{dynamischer Anteil}$$

wobei d = Dicke des Substrates (siehe Fig. 2).

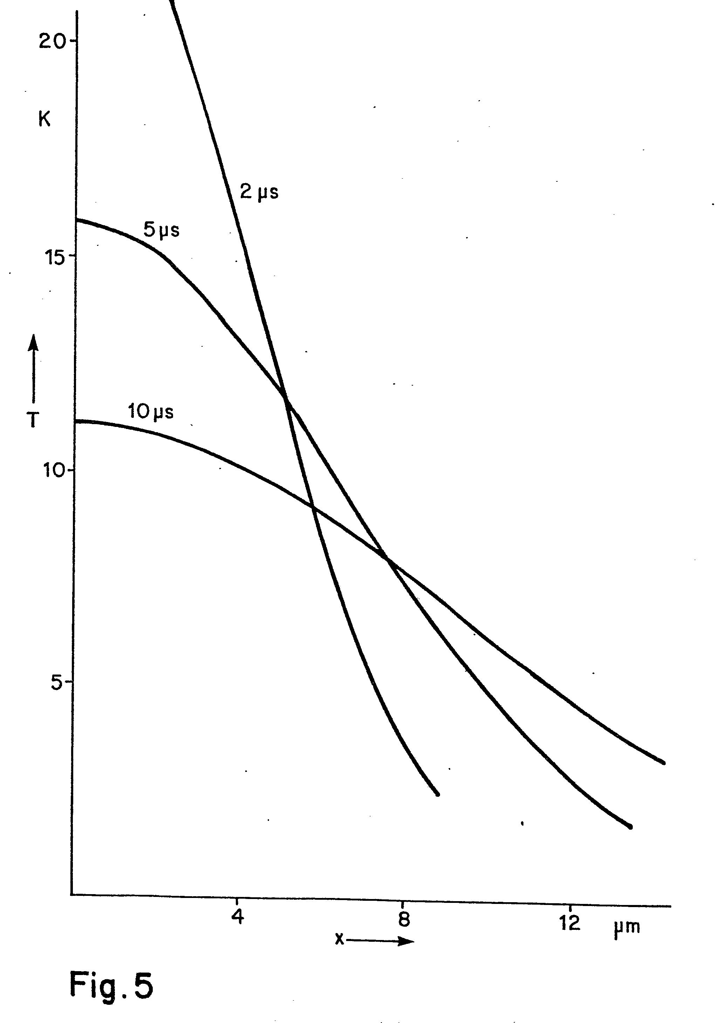

In Fig. 5 ist die Temperaturerhöhung des Keramiksubstrates 1 bei Stoßbeanspruchung für Leistungsspitzen der Dauer 2µs, 5µs, 10µs bei jeweils gleicher Energiedichte in Abhängigkeit des Abstandes x von der Substratoberfläche dargestellt.

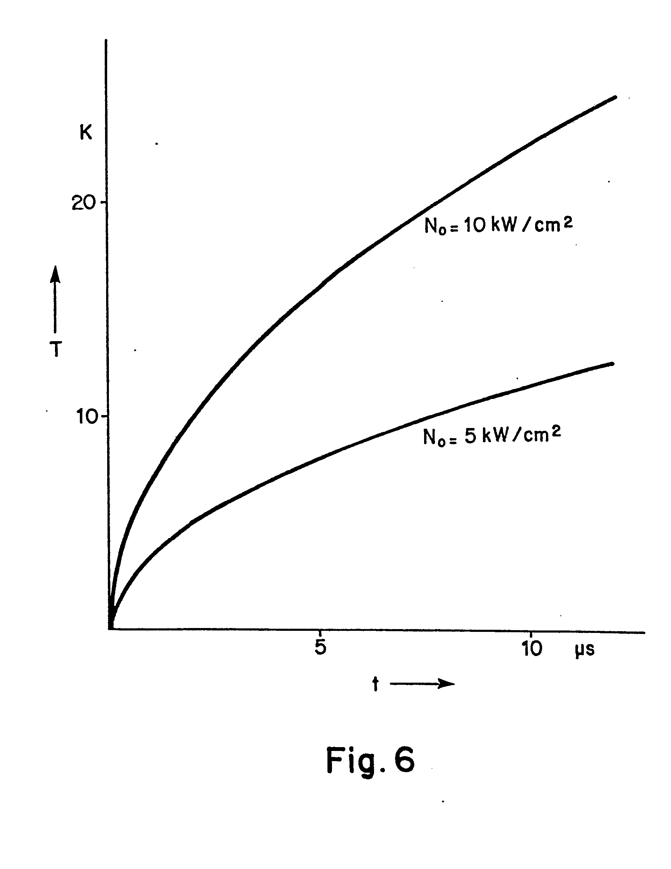

In Fig. 6 ist der zeitabhängige Temperaturanstieg der Keramiksubstratoberfläche (x = 0) bei Stoßbelastung während der Zeit t = 0 bis t = 10μs für verschiedene Leistungsdichten $N_0$ = 5 bzw. 10 Kw/cm² dargestellt.

Man erkennt aus den Figuren 5 und 6, daß etwa die ersten 10 bis 20μm des Keramiksubstrates 1 als Wärmekapazität zur Verfügung stehen zur Aufnahme der Stoßbeanspruchung. Da diese Stoßbeanspruchung hauptsächlich zu Druckspannungen in der widerstandsnahen Keramikschicht führen und Druckspannungen von Keramik gut aufgenommen werden, ist es zweckmäßig die Widerstände als Dünnnfilmwiderstände auszuführen. Dickfilmwiderstände mit ihrem bekanntlich schlechten Wärmeleitvermögen würden Stoßbeanspruchungen zunächst einmal adiabetisch auffangen und in wesentlichen Bereichen eine höhere Temperatur annehmen als die Keramikunterlage. Dies könnte zu Scherbeanspruchungen und Abplatzungen führen.

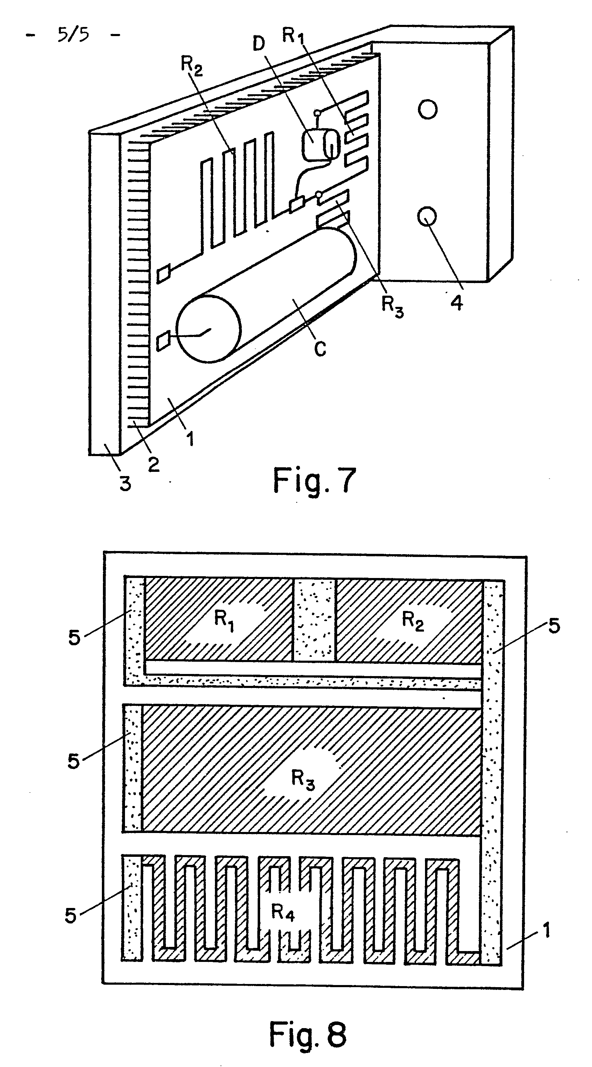

In Fig. 7 ist ein Thyristor-Beschaltungsmodul dargestellt, das zur Aufnahme aktiver und passiver Bauelemente dient. Auf dem Keramiksubstrat 1 sind drei Einzelwiderstände $R_1$, $R_2$ und $R_3$ als Dünnschichtwiderstände aufgebracht. Zwischen den Anschlüssen des Widerstandes $R_1$ ist eine Diode als Einzelbauelement angeordnet. Ein ebenfalls als Einzelbauelement ausgeführter Kondensator C ist mit dem Widerstand $R_3$ verbunden. Das Keramiksubstrat 1 liegt über dem Bürstenpaket 2 an der Wärmeableitplatte 3. Die Wärmeableitplatte 3 besteht z.B. aus Kupfer. Sie ist L-förmig gestaltet, wobei ihr längeres Teilstück zur Aufnahme des Keramiksubstrates 1 dient und ihr kürzeres Teilstück mit Bohrungen 4 zur Montage des Thyristor-Beschaltungsmoduls versehen ist.

In Fig. 8 ist ein reines Widerstandsmodul dargestellt. Auf einem Keramiksubstrat 1 sind dabei Widerstände $R_1$, $R_2$, $R_3$ und $R_4$ als Dünnschichtwiderstände aufgebracht. Das Keramiksubstrat 1 ist, wie unter Fig. 7 beschrieben und dargestellt, über ein (hier nicht dargestelltes) Bürstenpaket mit einer Wärmeableitplatte stoffschlüssig verbunden. Während die Widerstände $R_1$, $R_2$ und $R_3$ rechteckig und ganzflächig aufgebracht sind, ist der Widerstand $R_4$ mäanderförmig ausgestaltet. Bei einem Außenmaß des Keramiksubstrates von ca. 5 x 5 cm besitzt die Parallelschaltung der Widerstände $R_1$ und $R_2$ eine Gesamtfläche von ca. $3 cm^2$ bei einem Gesamt-widerstandswert von ca. 5 Ohm. Die mittlere Dauerleistung beträgt ca. 60W, während die Leistungsspitzen bis zu 26 000 W betragen können. Der Einzelwiderstand $R_3$ weist einen Widerstandswert von 12 Ohm bei einer Fläche von $6 cm^2$ auf. Die mittlere Dauerleistung beträgt 116 W, es sind Leistungsspitzen bis zu 32 000 W zulässig. Der Einzelwider-stand $R_4$ hat einen Widerstandswert von 10 KOhm bei einer Fläche von $3 cm^2$. Während eine mittlere Dauerleistung von 60 W zulässig ist, betragen die zulässigen Leistungsspitzen 120 W.

**A n s p r ü c h e**

1. Anordnung zur Wärmeabführung der in elektrischen bzw. elektronischen Bauteilen entstehenden Verlustwärme, mit einer Wärmeableitplatte und einem daran stoffschlüssig angeschlossenen elastischen Bündel von Einzelstegen, dadurch gekennzeichnet, daß aktive und passive Bauelemente, insbesondere Widerstände, auf einem Keramiksubstrat (1) angeordnet bzw. aufgebracht sind, wobei das Keramiksubstrat (1) über das elastische Bündel von Einzelstegen (2) potentialunabhängig mit der Wärmeableitplatte (3) zu einem Modul, insbesondere einem Beschaltungsmodul für Leistungshalbleiterbauelemente vereint ist.

2. Anordnung nach Anspruch 1, gekennzeichnet durch eine Ausführung der auf das Keramiksubstrat (1) aufgebrachten Widerstände als Dünnschichtwiderstände.

Fig. 1

Fig. 2

Fig. 3

Fig. 4

0046605

Fig. 5

Fig. 6

0046605

- 5/5 -

Fig. 7

Fig. 8